# EUROPEAN PATENT APPLICATION

(11) **EP 4 215 356 A1**
(43) Date of publication of application: **26.07.2023**
(21) Application number: 22382042.4
(22) Date of filing: 21.01.2022
(51) Int. Cl.: B32B 5/26, B32B 3/08, B32B 7/02, B32B 33/00

(54) **LAMINATED COMPOSITE STRUCTURE HAVING PRINTED FUNCTIONALITIES**

(71) Applicant: Fundación Tecnalia Research & Innovation, 20009 San Sebastián, Guipúzcoa (ES)
(72) Inventor: Bustero Martinez de Zuazo, Izaskun, Donostia - Guipúzcoa (ES); Vaquero Moralejo, Celina, Donostia - Guipúzcoa (ES); Bilbao Alba, Leire, Donostia - Guipúzcoa (ES); Maudes Puentedura, Jon, Donostia - Guipúzcoa (ES); Ollo Escudero, Olatz, Donostia - Guipúzcoa (ES); Obieta Vilallonga, Isabel, Donostia - Guipúzcoa (ES); Perez Marquez, Ana, Donostia - Guipúzcoa (ES); Villaverde Cendoya, Haizea, Donostia - Guipúzcoa (ES)
(74) Representative: Balder IP Law, S.L.

(57) **Abstract**

The present invention is directed to a laminated composite structure, the composite structure comprising a stack of at least one layer of a woven fabric and at least one first electrospun veil having a printed functionality on the surface of said veil; wherein the at least one first electrospun veil has a nominal weight between 2 and 10 g/m². Additionally, the present invention is directed to a method for manufacturing the laminated composite structure of the invention, a laminated composite structure obtainable by the method of the invention, and to the use of the laminated composite structure of the invention in transport, energy and textile sectors.

## Description

### TECHNICAL FIELD OF THE INVENTION

The present invention relates to the field of composites. In particular, the invention relates to a laminated composite structure having printed functionalities as well as to the method for obtaining the laminated composite structure. The present invention can for example be applied in the transport and energy sectors (automotive, railway, aeronautics, solar or wind power) as well as in the textile sector (medical, sport, fashion or military).

### BACKGROUND OF THE INVENTION

Multifunctional composites are materials with classic properties, such as high strength and stiffness, which in addition demonstrate some other functionalities, such as sensing, actuating, energy harvesting, self-annealing, health monitoring and morphing structure. Using multifunctional composites can offer significant savings in weight and volume of the final product or system in which it is integrated, e.g., aircraft and spacecraft, by eliminating bulky cables and chassis. Multifunctional composites can also contribute to prevent potential catastrophic failure and loss of life of a part by adding sensing capabilities capable of foreseeing possible failures of primary structures.

In many fields of technology, and due to different reasons, electronics and related products are usually integrated into different substrates. Exemplary reasons for such integration may be volume and/or weight savings and efficient integration of components. Exemplary fields of technology aiming at integrating electronics on different substrates are transport industry, including automotive, railway and aeronautics industry, product packaging, product housings, personal electronic devices, wearable electronics and smart fabrics, displays, toys and electrical household appliances.

There exist different techniques for providing functionalities - such as electronic components, integrated circuits and conductors - onto a substrate element. "Functional printing" or "printed electronics" is the use of electrically active materials printed on different substrates, to perform tasks combining mechanical and electrical/electronic functionalities, including integrated elements like sensors, lighting or photovoltaics. Printed electronics covers screen printing, flexography and inkjet printing, among others, through an additive printing process. Functional printing activities are typically performed on a planar (2D) substrate, either flexible or not. Examples of substrates typically used are PET, PC, textiles, paper and veils.

The design of multifunctional materials and structures can be implemented through the integration within a structural material of functional devices (i.e., devices which exhibit an additional function). Much research has been reported on functional parts, such as solar cells, thin-film batteries and copper foils, embedded into composite structures. Functional parts can be embedded during the laminating process and co-cured with fiber laminates. Other components, such as optical fibers and copper wires, can be introduced into dry fiber preforms during weaving of the dry fiber, to serve as sensors and antennas. These and other conventional methods are for example reviewed by Jagath Narayana et al in Materials Today: Proceedings 5 (2018) 5580-5590.

Currently, composite parts may have functionalities or structures which have been embedded therein during the fabrication process of the composite part. For example, a current automotive acceleration sensor was integrated in fiber-reinforced polymer parts in order to lightweight body parts (Klein Linda, Sensor Systems for FRP Lightweight Structures: Automotive Features Based on Serial Sensor Products, Sensors (2019), 19, 3088). Humidity sensors to detect moisture were embedded in composites, as moisture affects the operation and durability of laminate parts (Ebert F. et al. Integration of humidity sensors into fibre-reinforced thermoplastic composites, Procedia Technology 2 (2016) 207-213). Piezoelectric sensors and printed circuits have been embedded in composite laminated structures for structural health monitoring (Yang S.M. et al. Design and fabrication of a smart layer module in composite laminated structures, Smart Mater. Struct. 14 (2005) 315-320; Lin M. et al, The manufacture of composite structures with a built-in network of piezoceramics, Composites Science and Technology 62 (2002) 919-939).

In all cases mentioned above, the structural integrity, especially the interlaminar shear strength, is largely undermined and can result in delamination of the structures. Also, the embedded objects can act as blockers during the resin infiltration process, which will generate dry spots. The addition of the desired functions, such as sensors and printed circuits, within the composite structure cannot be at the cost of sacrificing the mechanical integrity, especially its interlaminar shear strength (ILSS). This is of especial relevance in certain sectors, such as the aeronautics sector. Therefore, the ultimate goal of multifunctional composites is to affordably and efficiently create multiple sophisticated and intelligent functionalities that become an inherent part of the structure in which they are integrated, without behaving as parasitic, so that their impact on the mechanical integrity of the composite structure is virtually eliminated.

An attempt to integrate functionalities within a composite structure is for example disclosed in US8932905B1, which refers to printing an organic semiconductor circuit on the surface of a composite structure. Another attempt is for example disclosed in US2017/0150602A1, wherein a flat polymer substrate having a circuit formed thereon is integrated with another polymer through a process of additive manufacturing. However, the obtained structure suffers from delamination and other failures. Another attempt is disclosed in EP3220064A1, which refers to a method of making a composite panel, in which different components are applied on a first electrically non-conductive layer. A second electrically non-conductive layer is coupled to the first electrically non-conductive layer. However, coupling the two layers requires the application of certain temperature and pressure, which may damage the integrated components. Yet another attempt is disclosed in EP3148299A1, which refers to a textile multi-layered injection moulded article made of an outer laminated textile fabric to which a laminated foil is attached. The laminated foil has a layer on which an electric circuit is printed and an encapsulation layer. However, the laminated foil causes damage to the structure.

Pa P. et al. (High frequency characterization of conductive inks embedded within a structural composite, Smart Materials and Structures, 24 (2015) 065010), have reported the application of silver ink by means of screen printing onto a prepreg (a combination of a matrix (or resin) and fiber reinforcement). In order to reduce mechanical problems, the resin must be precured in advance. In spite of the precuring stage, displacement in the applied ink tracks has been observed.

As in the above composites, textiles are moving towards flexible wearable textiles that have micro-electronic elements embedded in the textile fabric that can be used for varied classes of functionalities. There are different methods of integrating the microelectronic components for the development of smart textiles but all of them must be flexible, lightweight, washable, stretchable, non-intrusive, but also it is important that the resulting garment continues to be breathable. Printed textile-based electronics onto the surface of the substrate are one of the integrated methods and can be performed by printing techniques such as screen printing or inkjet printing (Review on the Integration of Microelectronics for E-Textile, Materials 2021, 14, 5113).

In 2017, Carey T. et al. (Fully inkjet-printed two-dimensional material field-effect heterojunctions for wearable and textile electronics, Nat. Commun., vol. 8, no. 1, pp. 1-11, 2017) studied an ink based on graphene that enable the printing of washable and biocompatible electronics on textiles like cotton and polyester. In this case they used planarization layers such as polyurethane,_polydimethylsiloxane (PDMS), polyimide, polyurethane (PU) or poly(vinyl alcohol) (PVA) to minimise the roughness of textiles and consequently to improve the device performance.

Paul G. et al. (The development of screen-printed conductive networks on textiles for biopotential monitoring applications, Sensors Actuators, A Phys., vol. 206, pp. 35-41, 2014) developed an innovative washable screen-printed network of electrodes associated with conductive tracks on textiles for medical applications. With the same aim as in the previous study, in this case a polyurethane paste was screen printed onto a woven textile to create a smooth and high surface energy interface layer.

Other authors such as Gozutok Z. et al. (Low-voltage textile-based wearable heater systems fabricated by printing reactive silver inks, Sensors and Actuators A 322 (2021) 112610) developed a low-voltage and light-weight fabric heater in wearable form by the help of printing particle-free silver inks directly on different textiles. In the study it was observed that cotton and viscose fabrics do not serve as efficient substrates for gaining conductivity due to their hydrophilic nature and in the other textiles the electrical conductivity could only be obtained after printing several layers.

Therefore, there is a need to obtain composites having embedded functionalities which overcome the drawbacks of conventional attempts to embed functionalities on composites and which are applicable in different sectors such as transport, energy or textile.

### BRIEF DESCRIPTION OF THE INVENTION

The authors of the present invention have developed a composite structure comprising a stack which comprises at least one electrospun veil having a printed functionality and a nominal weight between 2 and 10 g/m², and at least one additional layer, forming a laminate.

The use of this type of electrospun veil in the laminated composite structure of the present invention allows to print very fine lines (≤ 200 µm), which in standard layers of glass fiber is not feasible. As a consequence, different printing techniques such as screen-printing, micro-dispensing, aerosol-jet and ink-jet technique can be applied. In addition, its integration does not alter the physical properties of the final composite such as the weight or the tensile strength. Indeed, it has been observed that this type of electrospun veil having a printed functionality presents highly flexibility as well as high stretchability which is important for applications such as the textile one.

Therefore, a first aspect of the present invention is directed to a laminated composite structure comprising a stack of:
- at least one layer of a woven fabric; and
- at least one first electrospun veil having a printed functionality on the surface of said veil and being adjacent to at least one layer of a woven fabric;
wherein the at least one first electrospun veil has a nominal weight between 2 and 10 g/m².

A second aspect of the present invention is directed to a method for manufacturing the laminated composite structure as defined above, the method comprising the following steps:
a) providing at least one layer of a woven fabric and at least one first electrospun veil; wherein the at least one first electrospun veil has a nominal weight between 2 and 10 g/m²;
b) applying a printing paste, having viscosity below 600 Pa-s, on the surface of the at least one first electrospun veil, thus obtaining a printed functionality on the surface of the at least one first electrospun veil;
c) forming a laminate comprising the at least one first electrospun veil having the printed functionality on its surface of step b) and the at least one layer of a woven fabric; and
d) obtaining a laminated composite structure from said laminate.

A third aspect of the present invention is directed to a laminated composite structure obtainable by the method as defined above.

A final aspect of the present invention is directed to the use of the laminated composite structure in transport, energy and textile sectors.

Additional advantages and features of the invention will become apparent from the detailed description that follows and will be particularly pointed out in the appended claims.

### BRIEF DESCRIPTION OF THE DRAWINGS

Figure 1 schematically shows a stack of laminate for manufacturing a laminated composite structure, according to an embodiment of the invention.
Figure 2 shows an electrospun veil of PA6 on which an electronic circuit has been printed following the method of the invention and integration of LEDs and a connector on the printed electronic circuit.
Figure 3 shows the integration steps of different electrospun veils (including a colored electrospun veil) for obtaining a laminated composite structure, according to an embodiment of the invention.
Figures 4 show a laminated composite structure manufactured using carbon-fibers fabric having integrated LEDs and additionally having a colored electrospun veil.
Figure 5 show optical microscopy images of printed sensors on an electrospun veil of PA6 following the method of the invention.
Figure 6 shows a sensor printed on an electrospun veil of PU following the method of the invention.
Figure 7 shows sensors integrated on a composite using glass-fibers fabric according to an embodiment of the invention.
Figure 8 shows several temperature cycles carried out between room temperature and 105°C to a silver ink printed sensors based on an electrospun veil embedded in an epoxy/glass fibre composite PU veil and integrated in a composite according to an embodiment of the invention.
Figure 9 shows results of a bending test at three points for the printed sensors embedded in composite according to an embodiment of the invention.

### DETAILED DESCRIPTION OF THE INVENTION

The composite structure having embedded functionalities, described in the present invention, intend to solve the shortcomings of prior-art products. Thus, functional (or multifunctional) composites are obtained.

Therefore, a fist aspect of the present invention is directed to a laminated composite structure comprising a stack of:
- at least one layer of a woven fabric; and
- at least one first electrospun veil having a printed functionality on the surface of said veil and being adjacent to the at least one layer of a woven fabric;
wherein the at least one first electrospun veil has a nominal weight between 2 and 10 g/m².

In the context of the present invention, the term "laminated composite structure" refers to an assembly of layers of fibrous composite materials which can be joined to provide required engineering properties such as stiffness, strength and coefficient of thermal expansion. Layers of different materials may be used, resulting in a hybrid laminate.

In a particular embodiment, the laminated composite of the present invention is a polymer composite, that is to say, a composite whose matrix is made of polymeric resin.

As defined above, the laminated composite of the present invention comprises at least one layer of a woven fabric. In the context of the present invention, the term "woven fabric" refers to any fabric made by interlacing two or more threads at right angles to one another, which can be made of natural fibres, synthetic fibres or a mixture of both.

Non-limiting examples of woven fabrics suitable for the laminated composite material structure of the present invention are glass-fiber fabric, carbon-fiber fabric, natural fabric such as wool, skill and cotton, aramid woven fabrics, synthetic fabrics such as those of polyester, polypropylene, polyamide and polyethylene, or any combination of fabrics thereof.

In a particular embodiment, the at least one layer of a woven fabric is made of carbon fibers or glass fibers.

In another particular embodiment, the at least one layer of a woven fabric is made of natural fabric such as wool, skill or cotton.

In another particular embodiment, the at least one layer of a woven fabric is made of synthetic fabrics such as those of polyester, polypropylene, polyamide and polyethylene.

In another particular embodiment, the at least one layer of a woven fabric can comprise from 1 to 15 layers of woven fabric. In case of more than one layer of woven fabric, they can be made of the same or of different material within the same composite structure.

In yet another particular embodiment, at least one layer of a woven fabric comprises only one layer.

The laminated composite structure as defined above further comprises at least one first electrospun veil.

In a particular embodiment, the laminated composite structure as defined above further comprises at least one second electrospun veil adjacent to the at least one of first electrospun veil.

The at least one second electrospun veil has preferably a structural function, i.e., it servers for the purpose of improving the structure of the composite.

In particular embodiment of the invention, the laminated composite structure as defined above comprises one or two second electrospun veils adjacent to the at least one electrospun first veil.

In another particular embodiment, when the at least one layer of woven fabric is made of carbon fibers, the laminated composite structure as defined above further comprises at least one third electrospun veil located between the at least one first electrospun veil and the at least one layer of woven fabric.

The at least one third electrospun veil has preferably an isolating function, i.e., to ensure that the printed functionality remains electrically isolated from the carbon fibers of the at least one layer of woven fabric.

In an embodiment of the present invention, the laminated composite structure as defined above comprises one or two third electrospun veils located between the at least one first printed electrospun veil and the at least one layer of woven fabric.

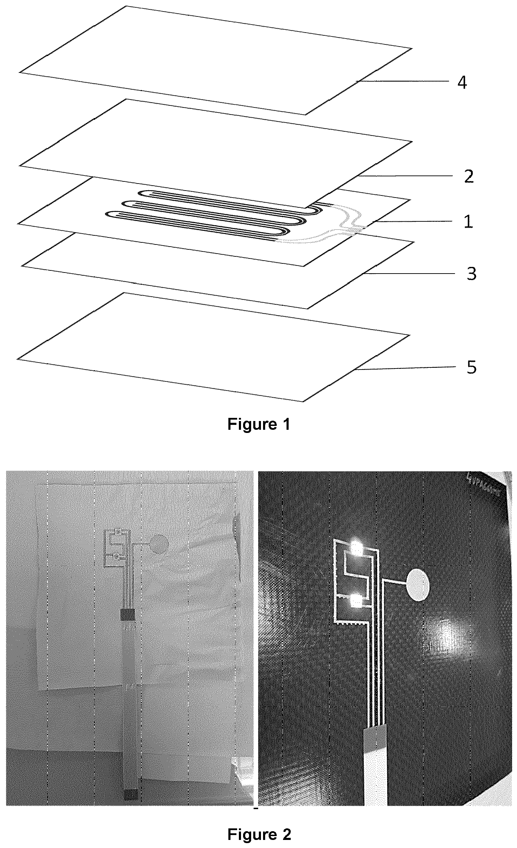

Figure 1 schematically shows a laminated composite structure according to an embodiment of the invention. In particular, Figure 1 shows one first electrospun veil having a printed functionality on the surface of said veil (1); one layer of a woven fabric (5) made of carbon fibers; one additional layer of woven fabric (4) made of glass fibers; one second electrospun veil (2) located between the first electrospun veil having a printed functionality (1) and the layer of woven fabric (4); and one third electrospun veil (3) located between the first electrospun veil having a printed functionality (1) and the layer of woven fabric (5).

The term "electrospun veil" refers to a structure based on nanofibers from one or more polymers and which are made by the well-known electrospinning technology. This technology is based on the continuous generation of a jet by means of immobilizing charges on the surface of a liquid droplet by applying a high voltage. The electrospun veils of the present invention have been developed from two different methods; needle electrospinning and neddle-free electrospinning. The most basic electrospinning process, referred to as needle electrospinning consists of a syringe in which the solution to be electrospun is located, a needle to which a high voltage is applied, and a grounded collector in which the fibers are collected as a nonwoven veil. The jet that is formed at the outlet of the needle is drawn during its flight to the collector, decreasing its diameter to the nanometric scale. In the needle-free electrospinning process, the solution is introduced in a rotating spinning electrode which is formed of several wires and connected to a high voltage supply. Due to the electrical field generated between the spinning electrode and the grounded electrode, thousands of jets are formed.

Polymers suitable for the electrospun veils of the present invention are selected from at least one of the groups of polycarbonates, polyamides, polyesters, polyurethanes, polymers containing styrene groups, polymers containing halogen groups, combinations thereof and biopolymers.

In an embodiment of the invention, the at least one first electrospun veil, the at least one second electrospun veil and the at least one third electrospun veil are made of a thermoplastic polymer, preferably selected from the group of polycarbonates, polyamides, polyurethanes, polyesters, polymer containing styrene groups, polymer containing halogen groups or combinations thereof; and biopolymers.

The at least one first electrospun veil, the at least one second electrospun veil and the at least one third electrospun veil can be made of the same polymer or made of different polymers, within the same composite structure.

The at least one first electrospun veil on which a functionality is printed is preferably a nonwoven polymer veil.

In an embodiment of the invention, the at least one first electrospun veil, the at least one second electrospun veil and the at least one third electrospun veil comprises nanofibers having a diameter between 50 and 1000 nm.

The at least one first electrospun veil comprises a printed functionality on its surface. In the context of the present invention, the term "printed functionality" refers to an embedded functionality by printing circuits or elements on the surface of an electrospun veil by means of well-known printing techniques such as screen-printing, micro-dispensing, aerosol-jet and ink-jet technique.

Non-limiting examples of printed functionalities suitable for the composite structure of the present invention are printed electrically conductive tracks or circuits and printed electrical contact paths.

The at least one first electrospun veil may comprises not only printed elements/circuits, but also hybrid components or elements, such as LEDs or connectors, non-printed on the at least one first electrospun veil. Rather, such non-printed components are coupled, attached, bonded or connected on the at least one electrospun veil. Only elements which, due to their nature and development technique, cannot be printed are attached to the at least one electrospun veil by other-more invasive- means. Examples of these elements are LEDs or connectors. By minimizing the amount of such elements, which typically occupy a minimum surface not exceeding a few square centimeters, the integrity of the structure and final composite is maximized.

Non-limiting examples of non-printed electronic components or elements suitable for the composite structure of the present invention are electrically conductive members, integrated circuits, integrated components, for example lighting components (e.g., LEDs), photovoltaics components, electric contact pads, sensors and on/off buttons.

The at least one first electrospun veil may further comprises electronic assemblies such as dielectric protection applied on conductive paths, circuits or components.

The laminated composite structure as defined above further comprises at least one second electrospun veil adjacent to the at least one electrospun first veil, in particular, the at least one second electrospun veil is adjacent to the side of the at least one electrospun first veil opposite to side adjacent to the one layer of woven fabric.

The at least one first electrospun veil, the at least one second electrospun veil and the at least one third electrospun veil have a nominal weight between 2 and 10 g/m².

In the context of the present invention, the term "nominal weight" refers to grams per square meter (g/m²) and it is measured by weighing standardized sized sections of a veil. For example, to calculate the nominal weight of a veil according to the present invention, several pieces of said veil having a size of 10 cm × 10 cm are weighed.

The authors of the present invention have found that using said nominal weight allows to print very fine lines (width ≤ 200 µm) of the printed functionality, which in standard glass fibers layers is not feasible. In addition, the integration of veils having this nominal weight does not increase the total weight of the final composite.

In another embodiment of the invention, the at least one first electrospun veil, the at least one second electrospun veil and/or the at least one third electrospun veil can further comprise particles or active agents. The particles can be of diverse nature: organic, inorganic, ceramic, carbonaceous. The particles or active agents can be located in the interior of the fibers of the veils and/or modifying their surface, for example by means of coatings. Said particles or active agents are incorporated to provide the composites with additional functionalities such as antibacterial properties, electrical properties, thermal conductivity or aesthetic properties.

A non-limiting example of particles or active agents suitable for the laminated composite structure of the present invention are Ag particles or TiO₂ particles incorporated in any of the electrospun veils in order to provide antibacterial functionality to the final laminated composite structure. These particles are preferably at or closed to the surface of the laminated composited, i.e., they are incorporated in the at least one first electrospun veil or, when present, in the at least one second electrospun veil.

Another non-limiting example of particles or active agents suitable for the laminated composite structure of the present invention are inorganic pigments, such as cobalt blue, green chromium (III) oxide or red synthetic iron oxide, incorporated in any of the electrospun veils in order to provide color (aesthetic functionality) to the final laminated composite structure. These particles can be incorporated at or closed to the surface of the laminated composited, i.e., they can be incorporated in the at least one first electrospun veil or, when present, in the at least one second electrospun veil; or at any deeper layer of the laminated composite structure when the superficial layers are transparent.

Yet another non-limiting example of particles or active agents suitable for the laminated composite structure of the present invention are carbon nanotubes incorporated in any of the electrospun veils in order to provide conductivity to the final laminated composite structure.

### Method of manufacturing the laminated composite structure

A second aspect of the present invention is directed to a method for manufacturing the laminated composite structure as defined above, the method comprising the following steps:
a) providing at least one layer of a woven fabric and at least one first electrospun veil; wherein the at least one first electrospun veil has a nominal weight between 2 and 10 g/m²;
b) applying a printing paste, having viscosity below 600 Pa-s, on the surface of the at least one first electrospun veil, thus obtaining a printed functionality on the surface of the at least one first electrospun veil;
c) forming a laminate comprising the at least one first electrospun veil having the printed functionality on its surface of step b); and the at least one layer of a woven fabric; and
d) obtaining a laminated composite structure from said laminate.

The method for manufacturing the laminated composite structure as defined above comprises a step (a) of providing at least one first electrospun veil and at least one layer of a woven fabric; wherein the at least one first electrospun veil has a nominal weight between 2 and 10 g/m².

In a particular embodiment of the invention; the step (a) of the method for manufacturing the laminated composite structure of the present invention can further comprises providing at least one second electrospun veil, and/or at least one third electrospun veil, wherein both, if present, have also a nominal weight between 2 and 10 g/m².

As previously defined, in an embodiment of the invention, the at least one first electrospun veil, the at least one second electrospun veil and the at least one third electrospun veil are made of a thermoplastic polymer, preferably selected from the group of polycarbonates, polyamides, polyurethanes, polyesters, polymer containing styrene groups, polymer containing halogen groups or combinations thereof; and biopolymers.

In a particular embodiment, the at least one first electrospun veil is made of polyamides, such as polyamide 6 (PA6), or polyurethanes.

In another particular embodiment, the at least one second electrospun veil is made of polyamides, such as polyamide 6 (PA6), or polyurethanes.

In a particular embodiment, the at least one third electrospun veil is made of polyamides, such as polyamide 6 (PA6), or polyurethanes.

The at least one of first electrospun veil, the at least one of second electrospun veil and the at least one third electrospun veil can be made of the same polymer or made of different polymers, within the same laminated composite structure.

As previously defined, in an embodiment of the invention, the at least one first electrospun veil, the at least one second electrospun veil and the at least one third electrospun veil comprises nanofibers having a diameter between 50 nm and 1000 nm, preferably between 70 nm and 550 nm.

The method for manufacturing the laminated composite structure as defined above further comprises a step (b) of applying a printing paste, having viscosity below 600 Pa-s, on the surface of the at least one first electrospun veil, thus making a printed functionality on the surface of the at least one first electrospun veil.

By printing the functionality on the at least one first veil, with which the composite is subsequently manufactured, the functionality becomes fully integrated/embedded within the composite, in a minimally invasive way. The structure of final composite is therefore not damaged.

In the context of the present invention, the term "printing paste", also referred to as "functional paste" refers to different types of fluids having, for example, conductive or sensing properties.

In embodiments of the invention, the paste is a conductive paste comprising: metallic particles, a binder and an organic solvent; the number of metallic particles being between 60 to 85 wt%. The number of metallic particles must be in the mentioned range in order to guarantee good conductivity of the conductive path printed on the first electrospun veil. The metallic particles have an average size in the range of 400 nm to 2 µm. In embodiments in which the metallic particles are substantially spherical, the average size refers to the average diameter of the particles. The metallic particles may be made of silver, copper, aluminum or other metals, or a combination thereof, such as a combination of silver and copper. Any suitable binder, such as a solvent-organic binder, and any suitable organic solvent, may be used.

Thus, a conductive paste (also referred to as conductive ink) is used to print a conductive track or path on an electrospun veil. A correct conductivity of the conductive paths printed on the electrospun veil depends on the viscosity and number of conductive particles of the conductive paste and on the type of printing method. Good conductivity is achieved when the nominal weight of the electrospun veil is between 2 and 10 g/m². In particular, good conductivity is achieved at least when the electrospun veil has a nominal weight between 2 and 10 g/m² and a conductive paste having viscosity below 600 Pa-s is used.

In embodiments of the invention, the paste is a sensing paste, the sensing paste being one of the following: a carbon-based paste, a polymeric paste having a conductive polymer or a magnetite-based paste.

The selected printing paste has viscosity below 600 Pa-s. For example, a paste having viscosity between 0.01 and 600 Pa-s may be used, such as between 0.1 and 600 Pa-s, or between 1 and 600 Pa-s, or between 10 and 600 Pa-s. In the context of the present invention, the viscosity of a printing paste refers, unless otherwise indicated, to a viscosity value measured with a rheometer at a temperature of 25°C and 1/s shear rate.

The lower the viscosity of the printing paste, the better is the fabric-paste union, because part of the paste impregnates the fibers of the veil -in addition to creating a paste layer on the veil. The impregnation of paste is also referred to as wettability. The higher the viscosity of a printing paste, the less it impregnates the fibers (and the paste, such as conductive paste, is deposited on the veil). Therefore, the viscosity of the printing paste becomes a key parameter.

As an example, when an electrospun veil, preferably having nominal weight below 10 g/m², and a paste having viscosity below 600 Pa-s, are used, conductive tracks having a minimum width of 150 µm may be obtained. In embodiments of the invention, the first electrospun veil has a thickness of at least 2 µm, such as least 4 µm or at least 20 µm or at least 40 µm or at least 60 µm.

A composite of optimized quality is obtained when an electrospun veil, having nominal weight below 10 g/m² is used, and a printing paste having viscosity below 600 Pa-s is used.

The selected printing paste can be applied on the surface of the at least one first electrospun veil by means of different well-known printing techniques, such as screen-printing, micro-dispensing, aerosol-jet or ink-jet. As a result, a printed functionality is obtained on the surface of said at least one first electrospun veil.

Therefore, the proposed method can work with a great variety of pastes, which enables to obtain a great variety of electronic assemblies on a great variety of geometries. The printing process of step (b) can be applied to obtain two-dimensional functionalities but also to obtain three-dimensional functionalities, for example, by using moulds having certain curvature while printing.

As an example of an embodiment of the invention, a printed functionality is obtained as follows: First, an electrospun veil is provided. Then, a printing paste, also referred to as functional paste, is selected. The printing paste may be a conductive paste, such as a paste comprising Ag, and/or Al; a sensing paste, such us a carbon-based paste, a polymeric paste and a magnetite-based paste; a dielectric paste or an adhesive paste. The selection of the paste to be used will be based on the type of element to be printed or applied. For example, when a conductive track needs to be printed, a conductive paste may be used; when a sensor needs to be printed, a sensing paste, such as a carbon-based paste, a polymeric paste or a magnetite-based paste, may be used.

The minimum width of the conductive paths printed on the first electrospun veil may be of around 200 µm. Typical maximum widths may be of several millimeters or even centimeters, depending on the requirements of the specific application of the composite. The thickness of the printed conductive path deposited on the surface of the first electrospun veil may be between 10 and 300 µm. Depending mainly on the chemical composition of electrospun veil and on the viscosity of the paste, the paste manages to impregnate the fabric to a larger or smaller extent. However, even when the paste manages to impregnate a veil to a large extent, a layer of paste is deposited on the veil, this layer having a minimum thickness of about 10 µm. This minimum thickness is obtained, for example, when a paste having viscosity lower than 100 Pa-s is used. On the contrary, for example when an electrospun veil with nominal weight (such as 2 - 10 g/m²) is used, and a paste having viscosity varying between about 400 - 600 Pa-s is applied, a deposited layer of paste of about 300 µm may be achieved. The obtained printed conductive paths do not disturb the flow of resin during a later stage of resin infiltration or application of prepreg.

In embodiments of the invention, the step (b) of the method further comprises, after applying the printing paste on the at least one first electrospun veil, curing the printed functionality following a thermal or UV process, using for examples a lamp, such as an IR lamp or a UV lamp.

As an example, once a layer of conductive paste is applied on a first electrospun veil, and the conductive path is therefore printed, the applied conductive paste is cured following for example a thermal process or a UV process, such that volatile material in the binder medium is driven off. The binder, such as organic binder (e.g., resin) is at least partially left to bind together the conductive particles, thus forming the electrically conducting lines. This may be done in different ways. In a possible embodiment, the printed electrospun veil is introduced in an oven at a temperature of 80°C-170°C for certain time, such as between 20 and 90 minutes. In another embodiment, in which a robotic system is used, the conductive paste applied on the printed electrospun veil is cured using a lamp, such as an IR lamp or a UV lamp. For example, but not limiting, a 200 W lamp having up to 90 W/cm² may be used for a certain time, such as between 30 s and 5 minutes. Good wetting and adhesion of the conductive pattern (path) to the printed electrospun veil is necessary, especially when non-flat (3D) composites are being manufactured. Good adhesion implies sufficient impregnation of conductive paste in the fibers of the printed electrospun veil. A conductive paste with bad wettability can be unbonded from the printed electrospun veil during the composite fabrication in a 3D mold. In particular, it has been observed that conductive paths deposited on the printed electrospun veil -rather than impregnating the fibers- tend to crack when the printed electrospun veil is manipulated.

Conductive paste may be used to print, in addition to conductive paths or tracks, capacity buttons (such as touch buttons) on specific points of the conductive paths. Capacity buttons are preferably printed using a screen-printing method. In embodiments of the invention, a screen mesh from around 61 to 165 th/cm, more preferably from 77 to 140 th/cm, may be used to deposit the functional paste. More than one screen print passes may be made to deposit a higher amount of printing paste on the substrate (the at least one first electrospun veil), thus obtaining a more homogeneous print. Capacity buttons may have a thickness of around 25 to 300 µm. In a particular example, their thickness is of around 50 µm. The applied capacity buttons are cured following a thermal process. In a possible embodiment, they are cured in an oven at a temperature of 100°C-170°C for certain time, such as between 20 and 90 minutes.

In addition to conductive tracks and optional capacitive buttons (when required), sensing elements may also be printed on the first electrospun veil. Sensing elements may be printed with a sensing paste, such as a carbon-based paste, a polymeric paste, a magnetite-based paste or silver-based paste. Sensing elements detect events or changes in its environment and send the captured information to other electronics or displaying devices. Sensing elements can be printed on the first electrospun veil and embedded to construct functional composites. For instance, temperature sensors detect changes in the environmental temperature. Electrical properties (for instance the resistivity) of some functional pastes, such as metallic paste, carbon-based pastes or polymeric pastes having a conductive polymer, are affected by the temperature. Therefore, they are sensitive to temperature and can be used to build sensing elements. In order to print sensing elements, different sensing pastes may be used, such as metallic paste, carbon-based pastes, polymeric pastes and magnetite-based pastes.

Carbon-based pastes may be used to print sensing elements in the circuit (for instance temperature or strain sensors). They can also be used as piezo-resistive pastes for, together with other techniques, such as ultrasound detection, detecting failure or delamination in composite parts. The carbon-based paste comprises a carbonaceous material, a binder and a solvent. The carbonaceous material is preferably one of the following materials: graphite, graphene and carbon nanotubes. Any suitable binder may be used, such as a solvent-organic binder. The binder may be a solvent-organic polymer. Any suitable solvent may be used, such as water. The carbon-based paste preferably comprises an amount of carbonaceous material (i.e., carbonaceous particles) of 30 - 55% (%weight solid content). For example, a carbon-based paste having an amount of solid material of 30-34% may be used. Or a carbon-based paste having an amount of solid material of 54-55% may be used. The particles may be made of graphite, graphene or carbon nanotubes, or a combination thereof. Sensing elements made of carbon-based pastes are preferably printed using a screen-printing method. In embodiments of the invention, a screen mesh from around 21 to 120 th/cm may be used to deposit the carbon-based paste. More than one screen print passes may be made to deposit a higher amount of printing paste on the substrate (the at least one first electrospun veil), thus obtaining a more homogeneous print. The applied carbon-based paste is preferably cured after each screen print pass. The applied carbon-based paste is cured, for example following a thermal process or a UV process. In a possible embodiment, it is cured after each screen print pass at a temperature between room temperature and 130°C for certain time, such as 15 minutes.

In addition, a dielectric paste may be used to protect printings made of a carbon-based paste (i.e., to prevent the resin of the composite from seeping through the carbon-based paste and eventually modifying it).

This is due to the fact that the resistivity value of the carbon-based paste printed on the electrospun veil may change during the infusion and curing of the resin in the later fabrication of the composite fabrication, the applied carbon-based paste is preferably insulated with an encapsulation. Encapsulation may be an encapsulating paste or a polymer film, such as a polyurethane film. In a particular embodiment, the carbon-based paste is surrounded by an encapsulating paste acting as dielectric material. Thus, during the manufacturing of the composite part, the polymer (i.e., resin) of which the plastic matrix is made, does not modify the resistance value of the carbon-based paste when the polymer (i.e., resin) penetrates within the fiber fabrics. Therefore, a dielectric paste must be applied on the carbon-based tracks or paths. Preferably, the dielectric paste is also applied at the other side (surface) of the carbon-based paste, forming a dielectric path that substantially overlaps the carbon-based paste. The applied dielectric paste is cured, for example following a thermal process or a UV process. The two paths (portions) of dielectric paste prevent the carbon-based paste from being modified when the resin is injected (or in general, when the resin penetrates within the fiber fabrics). Thus, the carbon-based paste is sandwiched between two dielectric portions/paths/layers. It is noted that complete layers of dielectric, such as dielectric films, for example a polyurethane film, deposited on the surface of the at least one first electrospun veil, are less preferred, in order to interfere as little as possible with the flow of resin during the manufacture of the composite part. The dielectric paste is preferably a polymeric dielectric paste.

The selected polymeric dielectric paste is preferably a 100% solid paste after curing. Non-limiting examples of polymeric dielectric materials that may be used as dielectric paste are: poly (4-vinylphenol) (PVP), poly (methyl methacrylate), Polyethylene Terephthalate, polyimide, Polyvinyl alcohol, Polystyrene, poly(vinyl pyrollidone), poly(vinyl chloride) and polyamides. When encapsulating paste (dielectric paste) is used as encapsulation, it is preferably deposited using a screen-printing method. When a polymer film is used as encapsulation, it is bonded to the at least one first electrospun veil by means of thermal pressing at a certain temperature, such as around 120 °C, for some seconds.

Polymeric pastes comprising conductive polymers may also be used to print sensing elements in the circuit (for instance temperature sensors). Polymeric pastes comprise organic polymers that conduct electricity and a solvent. The solvent may be water. Non-limiting examples of organic polymers that may be comprised in the polymeric paste, are: poly(3,4-ethylenedioxythiophene) (PEDOT), poly (p-phenylene sulfide) (PPS) and a combination of both. For example, a polymeric paste having between 0.01 - 5% (weight-%) of solid content (organic polymer) and between 95 - 99.99% of water may be used. Sensing elements made of polymeric pastes are preferably printed using a screen-printing method. In embodiments of the invention, a screen mesh from around 77 to 180 th/cm, preferably from 130 to 150 th/cm, may be used to deposit the polymeric paste. Sensors made of polymeric paste may have a thickness of around 25 to 80 µm. In a particular example, their thickness is of around 40 µm. The applied polymeric paste is cured following for example a thermal process or a UV process. In a possible embodiment, they are cured in an air convection oven at a temperature of 80 - 200°C for certain time, such as between 10 and 30 minutes.

The sensing paste may also be a magnetite-based paste. For example, a paste comprising magnetite, a binder and a solvent, may be used. Other components may be also comprised in the magnetite-based paste. For example, a paste may be used having at least 45% of magnetite (weight-%), 15 - 35 wt % (weight-%) of water, 5 - 15 wt % (weight-%) of estyrene-acrylate copolymer and <4% (weight-%) of glycerol.

Thus, the printing paste is applied on the electrospun veil, in such a way that a conductive path, optionally including one or more sensors, -plus any other element connected thereto is-obtained, integrated within (printed in) the at leat one first electrospun veil.

For example, in order to print an electronic functionality comprising a lighting device with an on/off button based on a capacitive sensor, in a veil, the following steps will be carried out. First, a prototype must be designed, including designing an electrical circuit drawn for example in CAD. Then, the electrical paths and a capacitive button must be printed with a conductive paste on an electrospun veil. Sensors can also be printed on the electrospun veil, using either a carbon-based paste or a polymer-based paste. The conductive paste must be then cured, usually by a thermal process or a UV process. Components, such as LEDs and connector, can be placed, for example bonded by a conductive adhesive ink.

In embodiments of the invention, the method further comprises a step (c) of forming a laminate comprising the at least one first electrospun veil having the printed functionality on its surface of step b) and at least one layer of a woven fabric.

In an embodiment of the invention, step (c) of the method of the present invention can comprises forming a laminate further comprising at least one second electrospun veil adjacent to the first electrospun veil; and/or at least one third electrospun veil located between the at least one first electrospun veil and the at least one layer of woven fabric.

The laminate formed in step (c) can be a monolithic part or part of a sandwich composite (foam core, honeycomb core, etc.).

In order to embed the functional veil, and thus obtain the composite, different composite manufacturing processes may be used depending on the specific applications. Among possible lamination processes, the following automatic and manual processes may be used: ATL (Automated Tape Layer), AFP (Automatic Fiber Placement), Hand-layup, etc.

The method of the present invention further comprises a step (d) of obtaining a laminated composite structure from said laminate.

In other words, for completing the composite, a thermoset composite matrix may be introduced following conventional techniques, such as as prepreg (in which case the stack or laminate needs at least one prepreg layer), as a resin film or by infiltration of liquid resins based on different methods (Resin Transfer Moulding, infusion). Alternatively, a thermoplastic matrix may be introduced within the laminate of step (c) following a process of in-situ polymerization of the monomer. Thus, the laminate is embedded in polymeric resin in order to manufacture the composite. The resin may be provided following different conventional polymerization techniques, such as:
- In liquid form, for example using techniques like vacuum infusion or resin transfer moulding (RTM) for thermosets or by in-situ polymerization of thermoplastic monomers. For example, polyamide (PA) composites can be obtained (directly polymerizing in a 3D mould or obtaining the composite in planar moulds);
- Using preimpregnated fibre (prepreg), in which a fiber fabric is impregnated with resin, such as phenolic or epoxy resins; as already described, in this case the prepreg already is included in the laminate, but not yet cured; or
- As a resin film.

When a mould is used, the mould may be flat or curved. Therefore, 2D or 3D composite parts can be obtained. Resins or monomers having viscosities below 200 Pa-s have been tested and offer excellent results. One skilled in the art will understand that any other conventional processes of obtaining a laminated composite may be followed, or any step of a conventional process may be altered within the well-established expertise of the skilled person.

In embodiments of the invention, the stage of obtaining a laminated composite structure from said laminate is done following a thermoforming process, an adhesive bonding process, an in-situ polymerization process, an infiltration process or a prepreg process.

In a particular embodiment, a thermoforming process is followed. In particular, a thermoforming process is used to deformed a thermoplastic sheet into a specific shape by using a mold. The process starts with the heating of a flat plate like sheet of plastic which is then manipulated by either applying pressure or using vacuum. This process allows for example a waterproof textile material keep its characteristics intact shaping without any seams.

In another particular embodiment, an adhesive bonding process is followed. In particular, adhesive bonding is used to fasten two surfaces together, usually producing a smooth bond. This joining technique involves glues, epoxies, or various plastic agents that bond by evaporation of a solvent or by curing a bonding agent with heat, pressure, or time.

In another particular embodiment, an in-situ polymerization process is followed. In particular, an in-situ polymerization process of a thermoplastic monomer (such as a lactams) is used to obtain polyamide composites. Therefore, in this case the resin may be polyamide. The polymerization is performed directly in a mould. First, the mould is heated. When it reaches certain temperature, such as about 165 °C, the stack of fiber fabrics (including the printed veil), which may be pre-formed. A monomer, such as caprolactam, and a catalyst component are injected in the mold for several seconds, and the polymerization is performed. The composite part is then demoulded. A detailed disclosure of this process is for example given in US9290622-B2. After demoulding, a thermoforming process may be performed.

In another particular embodiment, a technique of infusion (infiltration) is followed. The resin may be an epoxy resin. First, the stack of fiber fabrics (including the printed veil) is laid up in a mould. A vacuum bag is then prepared. It is then compressed. The applied vacuum may be for example of 0.75 - 1 bar at between 60 - 250 °C for several seconds or minutes. A resin (such as epoxy) is then injected at room temperature into the compressed vacuum bag. The assembly is then cured, for example in a heater or in an oven, wherein polymerization takes place. The composite part is then demoulded.

In another particular embodiment, fiber preimpregnated with resin (also referred to as prepreg) is used. The resin may be a phenolic resin or an epoxy resin. In this process, the reinforcement fiber fabric has been pre-impregnated with a resin matrix in a certain ratio. When this technique is used, the printed electrospun veil may be for example sandwiched between two prepregs, or deposited on or beneath one prepreg. One or more dry fabrics may optionally be added (stacked). Preferably, the stack formed by the printed veil and at least one prepreg is compacted in order to remove air, for example using a roller. Then a vacuum bag is created. The applied vacuum may be of 0.75 - 1 bar. The assembly is cured, for example in a heater, to allow the flow of resin to impregnate the fiber fabrics. For example, between 45 min and 2 hours at a temperature of 90 - 150°C. The composite part is then demoulded.

In summary, the proposed method as defined above allows obtaining monolithic or sandwich laminated composite structures, including 3D parts, incorporating functionalities, like sensing or cabling, embedded in the final composite.

Thus, a third aspect of the present invention is directed to a laminated composite structure obtainable by the method as defined above.

### Applications of the laminated composite structure

The laminated composite structure of the present invention finds special advantages in the energy sector and transport industrial sector, including automotive, railway and aerospace sector, and textile sector, including clothing sector, because in these sectors it is definitely desirable to have composite having printed functionalities, such as sensors, lighting and heating elements, embedded thereon, without introducing delamination or other defects in the composite.

Thus, a final aspect of the present invention is directed to the use of the laminated polymer composite structure as defined above in transport, energy and textile sectors.

### EXAMPLES

### Example 1: Embedded conductive paths and LEDs in epoxy resin composite

An epoxy resin composite having embedded conductive path and LEDs is shown in **Figure 2****.** They have been manufactured as follows. Carbon-fiber fabrics having nominal weights of around 100 - 600 g/m² were used. Conductive paths were printed on electrospun Polyamide 6 veil by screen printing (using a screen-printing mesh of 77/48 th/cm with a silver conductive paste, having 73% solid content and viscosity of 22-27 Pa-s. The conductive paste was cured in an oven at 120-130 °C for 30 min. Once the conductive tracks were printed on the electrospun veil, connector was bonded with isotropic conductive adhesives using a micro-dispensing method (with tips having inner diameter of 0.41 mm and applied pressure of around 0.4 - 1 bar). Other rigid components (LEDs) were positioned and bonded with a pick&place robot. The printed electrospun Polyamide 6 veil is shown in **Figure 2****.** Then, the printed veil was stacked with seven fabrics of carbon-fiber. Additionally, an electrospun Polyamide 6 veil having a nominal weight around 5 g/m², in order to protect the printed conductive paths, and two electrospun veils of Polyamide 6 having a nominal weigth around 5 g/m², in order to isolate the printed circuit paths and LEDS from the carbon-fiber layer, were included in the composite.

A composite part was fabricated through an infusion process. The stack of carbon-fiber fabrics and the electrospun veils (one of which having been printed and with the rigid components bonded) was infused with Epoxy resin using a flat mould in vacuum conditions (0.75-1 bar). In **Figure 2****,** the stack is formed by seven additional layers of carbon-fiber. The composite is cured in an oven at 90 °C for 1.5 hours.

### Example 2: Embedded conductive paths and LEDs in epoxy resin composite with color electrospun veils

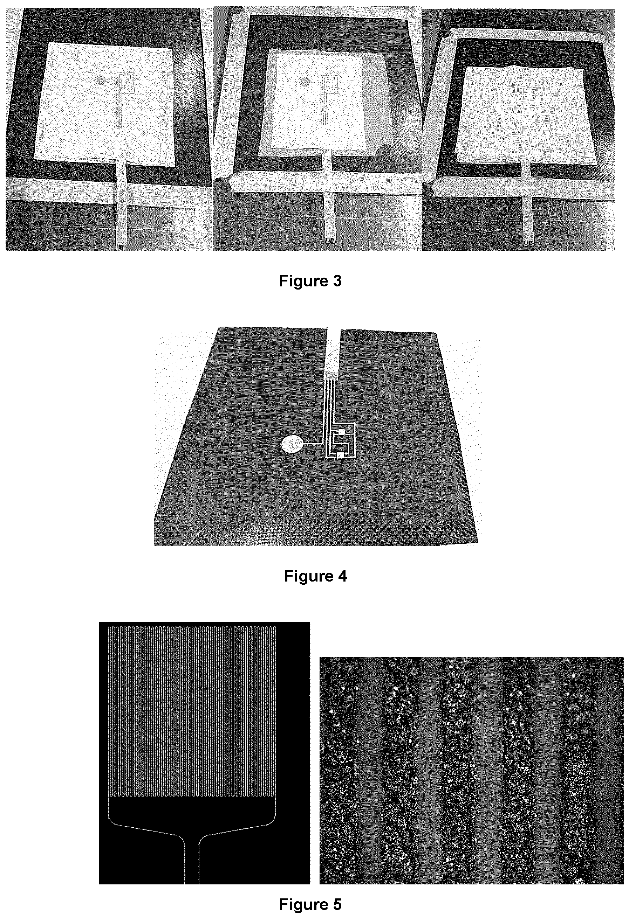

An epoxy resin composite having embedded conductive path and LEDs with color electrospun veils is shown in **Figure 3****.** They were manufactured as follows. Carbon-fiber fabrics having nominal weights of around 200 g/m² were used. Conductive paths were printed on electrospun Polyamide 6 veil by screen printing (using a screen-printing mesh of 77/48 th/cm with a silver conductive paste, having 73% solid content and viscosity of 22-27 Pa-s. The conductive paste was cured in an oven at 120-130 °C for 30 min. Once the conductive tracks were printed on the electrospun veil, connector was bonded with isotropic conductive adhesives using a micro-dispensing method (with tips having inner diameter of 0.41 mm and applied pressure of around 0.4-1 bar). Other rigid components (LEDs) were positioned and bonded with a pick&place robot. The printed veil was stacked with seven fabrics of carbon-fiber and a blue electrospun veil, based on PA6 nanofibers with a inorganic pigment. This colour veil was placed as a first layer in the composite (**Figure 4**). Additionally, an electrospun Polyamide 6 veil having a nominal weight around 5 g/m², in order to protect the printed conductive paths, and two electrospun veils of Polyamide 6 having a nominal weigth around 5 g/m², in order to isolate the printed circuit paths and LEDS from the carbon-fiber layer, were included in the composite. A composite part was fabricated through an infusion process. The stack of carbon-fiber fabrics and the electrospun veils (one of which having been printed and with the rigid components bonded) was infused with Epoxy resin using a flat mould in vacuum conditions (0.75-1 bar). In **Figure 3**, the stack is formed by seven additional layers of carbon-fiber. The composite is cured in an oven at 90 °C for 1.5 hours.

### Example 3: Embedded stress/strain and temperature sensors in epoxy resins composite

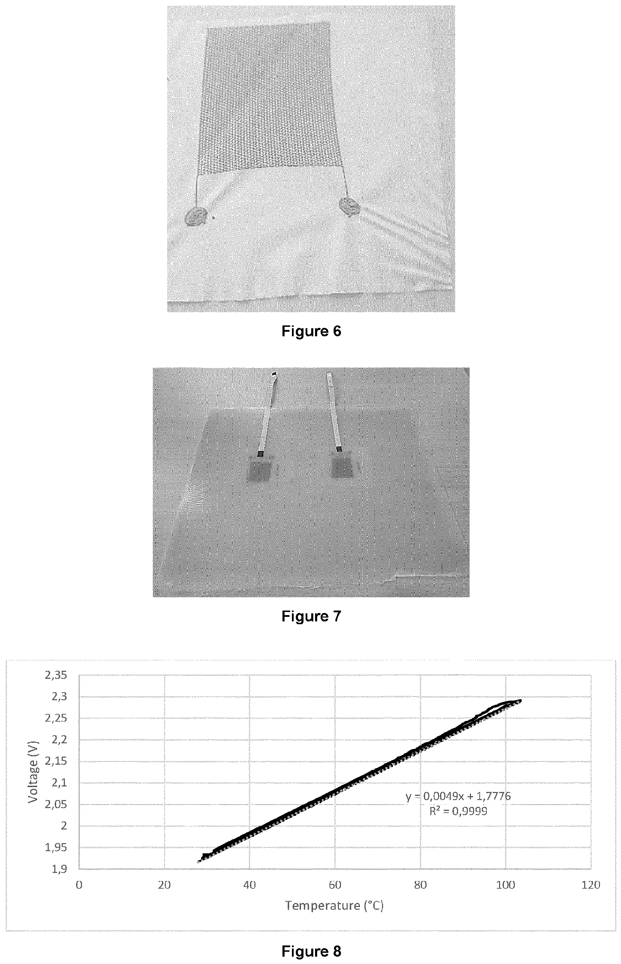

An epoxy resin composite having embedded temperature sensors is shown in **Figure 5**. It was manufactured as follows. Glass-fiber fabrics having nominal weight of 100g/m² have been used. On polyurethane electrospun veil, sensing lines (150µm line width and 200µm line gap) and pads made of conductive paste were deposited by screen-printing (using a screen-printing mesh of 130-30 th/cm) and then cured. The sensing paste was a silver-based paste having 63-68% of solid content and viscosity of 35 Pa-s. The printed conductive paste was cured in an oven at 80 °C for 1h. A connector was bonded with an isotropic conductive adhesive using a microdispensing method (using a dispensing tip of inner diameter of 0.41 mm and 7applied pressure of around 0.4-1 bar). The printed electrospun veil was shown in **Figure 6**. A stuck of glass-fiber fabrics and printed polyurethane electrospun veil having rigid components bonded thereon, was formed. A composite was then fabricated through an infusion process. The stuck of glass-fiber fabrics was infused with Epoxy resin. The sample is cured in an oven at 90 °C for 1.5 hours. The resulting composite part is shown in **Figure 7****.**

Temperature cycles between room temperature and 100 °C were carried out on the sensors printed on the polyurethane electrospun veil and embedded in the composite. The behavior was linear and repetitive after three cycles as shown in **Figure 8****.** The sensor showed a sensitivity of 4.9 mV/°C for a current intensity of 1 mA.

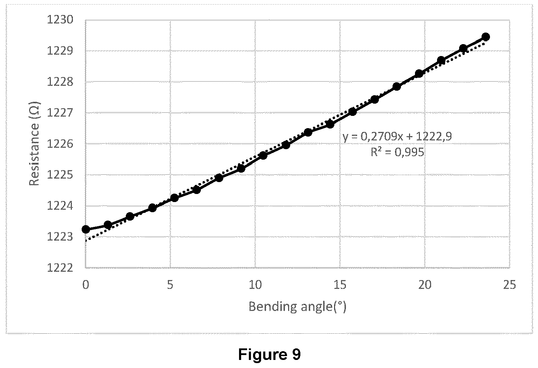

The printed sensors embedded in the composite was characterized from a bending test at three points, obtaining a sensitivity of 0.27Ω/°C for a current intensity of 1 mA, as shown in **Figure 9****.**

In summary, the proposed method allows obtaining composite parts having printed (such as micro-dispensed or screen-printed) electric conductive structures, including sensing elements and/or other components, embedded within the composite part. The composite parts may be 2D or 3D. Conductive paths, stress/strain and temperature sensors and other elements have been printed on an electrospun veil which can be non-intrusively embedded in a composite following standard manufacturing processes. It has been proved that printed conductive paths do not disturb the flow of resin when later infiltrating or doing the prepreg.

The invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

Example 4: Characterization of tensile properties of veils having printed conductive paths.

The tensile properties of several electrospun polyurethane veils having printed conductive paths according to the present invention were characterized (Table 1).

**Table 1. Deformation tests.**

| Specimen | Maximun Load (N) | Ultimate Strength (MPa) | Elongation at break (%) |
|---|---|---|---|
| 1 | 9,76 | 4,88 | 141,62 |
| 2 | 12,37 | 6,19 | 146,55 |
| 3 | 12,98 | 6,49 | 157,77 |
| 4 | 9,21 | 4,61 | 119,58 |
| 5 | 10,97 | 5,49 | 127,85 |

The results showed an average maximum stress of 5,53Mpa and a maximum deformation of 140%, which demonstrated the high capacity of the printed veils according to the present invention to deformation for their integration in textiles.

## Claims

1. A laminated composite structure, the composite structure comprising a stack of:
- at least one layer of a woven fabric; and
- at least one first electrospun veil having a printed functionality on the surface of said veil and being adjacent to the at least one layer of a woven fabric;
wherein the at least one first electrospun veil has a nominal weight between 2 and 10 g/m².

2. The laminated composite structure according to claim 1, further comprising at least one second electrospun veil adjacent to the at least one first electrospun veil.

3. The laminated composite structure according to any of claim 1 or 2, wherein the at least one layer of a woven fabric is made of carbon fibers, and the laminated composite structure further comprises at least one third electrospun veil located between the at least one first printed electrospun veil and the at least one layer of woven fabric.

4. The laminated composite structure according to any of claims 1 to 3, wherein the at least one first electrospun veil, the at least one second electrospun veil and/or the at least one third electrospun veil is a polymeric veil.

5. The laminated composite structure according to claim 4, wherein the polymeric veil is made of a thermoplastic polymer, preferably selected from the group of polycarbonates, polyamides, polyurethanes, polyesters, polymer containing styrene groups, polymer containing halogen groups, combinations thereof and biopolymers.

6. The laminated composite structure according to any of claims 1 to 5, wherein the at least one first electrospun veil further comprises particles or active agents.

7. The laminated composite structure according to any of claims 1 to 6, wherein the composite further comprises at least one electronic component attached to the at least one first electrospun veil.

8. The laminated composite structure according to any of claims 1 to 7, wherein the composite is a polymer composite.

9. Method for manufacturing the laminated composite structure according to any of claims to 1 to 8, the method comprising the following steps:
a) providing at least one layer of a woven fabric and at least one first electrospun veil; wherein the at least one first electrospun veill has a nominal weight between 2 and 10 g/m²
b) applying a printing paste, having viscosity below 600 Pa-s, on the surface of the at least one first electrospun veil, thus obtaining a printed functionality on the surface of the at least one first electrospun veil;
c) forming a laminate comprising the at least one first electrospun veil having the printed functionality on its surface of step b) and at least one layer of a woven fabric; and
d) obtaining a laminated composite structure from said laminate.

10. The method according to claim 9, wherein step (a) further comprises providing:
- at least one second electrospun veil; and/or
- at least one third electrospun veil located between the at least one first printed electrospun veil and the at least one layer of woven fabric,
wherein the at least one layer of a woven fabric is made of carbon fibers.

11. The method according to claim 10, wherein the printing paste is a conductive paste or a sensing paste.

12. The method of any one of claims 9 to 11, further comprising, after applying the printing paste on the at least one first electrospun veil in step b), curing the printed functionality following a thermal or UV process.

13. The method of any one of claims 9 to 12, wherein the step d) of obtaining a laminated composite structure from said laminate is done following thermosetting process, adhesive bonding process, an in-situ polymerization process, an infiltration process or a prepreg process.

14. A laminated composite structure obtainable by the method according to any of claims 9 to 13.

15. Use of the laminated composite structure according to any of claims 1 to 8 and 14 in transport, energy and textile sectors.
